# EUROPÄISCHE PATENTSCHRIFT

(11) **EP 1 052 308 B1**
(45) Veröffentlichungstag und Bekanntmachung des Hinweises auf die Patenterteilung: **24.03.2010**
(21) Anmeldenummer: 00109660.1
(22) Anmeldetag: 06.05.2000
(51) Int. Cl.: C23C 16/40, F28F 19/02, C23C 16/00

(54) **Verfahren zur Beschichtung eines Wärmetauschers**
Process for coating of a heat exchanger
Procédé de revêtement d'un échangeur de chaleur

(30) Priorität: 12.05.1999 DE 19923000; 18.05.1999 DE 19922743; 28.04.2000 AT 7582000
(43) Veröffentlichungstag der Anmeldung: 15.11.2000
(73) Patentinhaber: Vaillant GmbH, 42859 Remscheid (DE)
(72) Erfinder: Gabler, Volker, 50733 Köln (DE); Plawer, Jan, 40237 Düsseldorf (DE)
(74) Vertreter: Hocker, Thomas

(56) Entgegenhaltungen:
- EP-A- 1 052 307
- GB-A- 2 306 510
- PATENT ABSTRACTS OF JAPAN vol. 1998, no. 03, 27. Februar 1998 (1998-02-27) & JP 09 300095 A (SUMITOMO LIGHT METAL IND LTD), 25. November 1997 (1997-11-25)
- PATENT ABSTRACTS OF JAPAN vol. 1997, no. 01, 31. Januar 1997 (1997-01-31) & JP 08 232082 A (MITSUI ENG &SHIPBUILD CO LTD), 10. September 1996 (1996-09-10)

## Beschreibung

Die Erfindung bezieht sich auf ein Verfahren gemäß dem Oberbegriff des Anspruches 1.

Wärmetauscher von gasbeheizten Wasserheizern sind im Betrieb einem ständigen Angriff einer korrosiven Umgebung ausgesetzt, wodurch sich eine entsprechend begrenzte Lebensdauer der Wärmetauscher ergibt, auch wenn die Wärmetauscher aus hochwertigen Werkstoffen hergestellt sind, wie z.B. Edelstahl.

Ziel der Erfindung ist es, ein Verfahren anzugeben, durch das sich eine deutlich höhere Lebensdauer der Wärmetauscher ergibt, auch wenn diese im Brennwertbetrieb eingesetzt sind.

Erfindungsgemäß wird dies bei einem Verfahren der eingangs erwähnten Art durch die kennzeichnenden Merkmale des Anspruches 1 erreicht.

Durch die vorgeschlagenen Maßnahmen wird eine Keramik-, bzw. Silikatbeschichtung auf einfache Weise auf den Wärmetauscher aufgebracht, die diesen gegen einen Korrosionsangriff sehr weitgehend schützt. Dabei schützt die Beschichtung gegen den Angriff von Kondensat, wie es bei einem Brennwertbetrieb anfällt, das verschiedene Säuren, wie Schwefelsäure, Salpetersäure u.a., wie auch Chlor-Ionen enthält.

Durch die Beschichtung kann die Wandstärke des Wärmetauschers bei gleicher oder höherer Dauerhaltbarkeit des Wärmetauschers auch geringer gehalten werden, wodurch sich ein höherer Wirkungsgrad, sowie ein geringerer Materialverbrauch bei der Herstellung und ein niedrigeres Gewicht des Wärmetauschers ergeben.

Weiter ergibt sich auch der Vorteil, daß aufgrund des Umstandes, daß das Grundmaterial des Wärmetauschers mit chemisch aggressiven Medien aus den Verbrennungsgasen aufgrund der Beschichtung nicht in Kontakt kommt, ein geringwertigerer Werkstoff, oder ein Werkstoff mit besserer Wärmeleitfähigkeit verwendet werden kann, wie z.B. Messing.

Durch die höhere flächenspezifische Wärmeübertragungsleistung aufgrund der geringeren Wandstärke und besseren Wärmeleitfähigkeit des Grundmaterials ist es bei unveränderter Baugröße des Wärmetauschers möglich, höhere Wärmeleistungen zu übertragen.

Durch die Beschichtung vermindern sich auch die Ablagerungen an dem Wärmetauscher, die in regelmäßigen Abständen entfernt werden müssen.

Durch die Merkmale des Anspruches 2 ergibt sich eine einfachere Beschichtung, welche sich vorteilhaft in der Großserienfertigung auswirkt.

### Die Erfindung wird nun anhand der Zeichnung näher erläutert. Dabei zeigen:

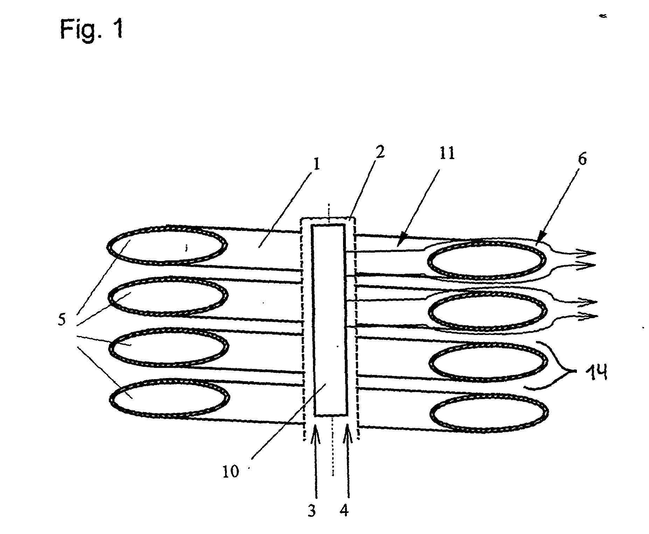

Fig. 1 schematisch die Beschichtung einer Rohrwendel im Schnitt und

Fig. 2 schematisch die Beschichtung eines montierten Wärmetauschers.

Bei der Beschichtung einer Außenwandung einer Rohrwendel 1 wird in einem Rohr 2 ein Prozeßgas 3, dem ein Beschichtungswerkstoff 4, wie z.B. SiO₂ oder Al₂O₃ beigegeben ist, mittels einer Plasmawelle 10 aktiviert. Das Rohr 2 ist so im hohlen Zentrum der Rohrwendel 1 angeordnet, daß der entstehende Plasmastrom 11 und der Beschichtungswerkstoff 4 im wesentlichen radial nach außen und zwischen den Abständen 14 der einzelnen Rohrwindungen 5 hindurch strömt.

Dabei lagert sich der Beschichtungsstoff 4 an der Oberfläche 6 der Rohrwendel 1 ab und bildet eine Schicht, die die Rohrwendel 1 von einem Korrosionsangriff schützt.

Die Beschichtung kann bei Atmosphärendruck oder besser unter einem verminderten Druck durchgeführt werden.

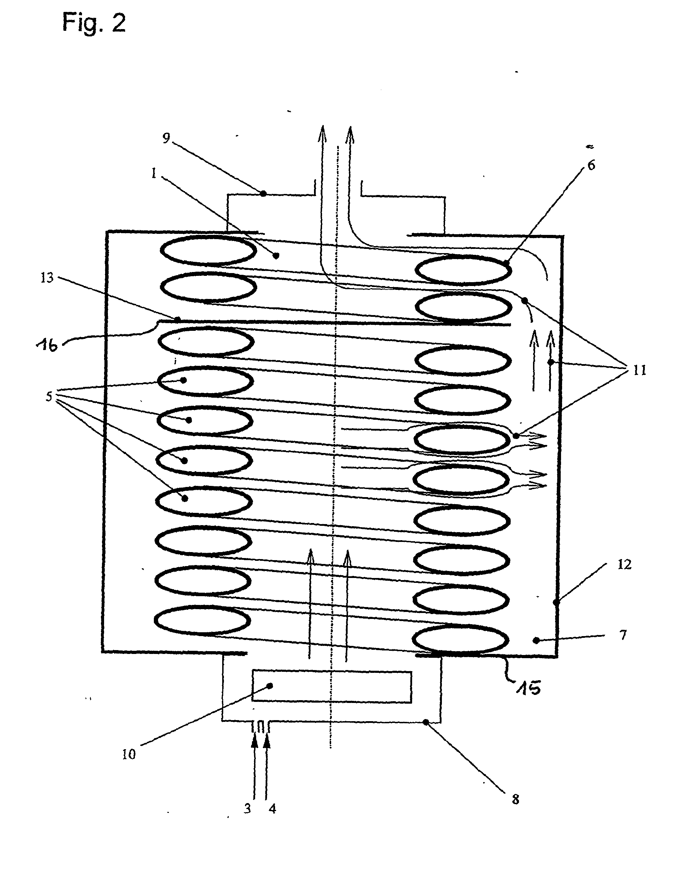

Bei der Ausführungsform des Verfahrens nach der Fig. 2 wird ein als Rohrwendel 1 ausgebildeter Wärmetauscher 12, der in einer Brennkammer 7 eines Wasserheizers angeordnet ist, beschichtet. Dabei wird die offene Unterseite 15 der Brennkammer 7 mit einer Kammer 8 abgeschlossen. In die Kammer 8 werden das Prozeßgas 3 und der Beschichtungsstoff 4 zugegeben und mittels der Plasmaquelle 10 aktiviert.

Der entstehende Plasmastrom 11 nimmt den gleichen Weg wie die beim üblichen Betrieb der Brennkammer durch einen Brenner entstehenden Abgase und durchströmt die Zwischenräume zwischen den einzelnen Windungen 5 der Rohrwendel 1 in radialer Richtung nach außen. Dieser Weg ist durch eine Unterteilung 13 bedingt. Der beladene Plasmastrom 11 umströmt in weiterer Folge die Unterteilung 13 bzw. deren Peripherie 16, durchströmt die Zwischenräume zwischen den restlichen Windungen 5 und strömt über einen Abgasabzug 9 ab. Der Abgasabzug 9 ist so eingerichtet, daß sich in der Kammer 7 Atmosphärendruck oder Grobvakuum einstellt. Das Beschichtungsmaterial 4 lagert sich außen an den Windungen 5 des Wärmetauschers 12 an und bildet die Beschichtung 6.

Auf diese Weise ist es auch möglich, bereits montierte Wärmetauscher 12 mit einer Beschichtung 6 zu versehen und damit deren Korrosionsbeständigkeit zu erhöhen.

## Patentansprüche

1. Verfahren zur Beschichtung eines Wärmetauschers, insbesondere eines Rohrwendel-Wärmetauschers (1), **dadurch gekennzeichnet, dass** der Wärmetauscher (1), der in einer Brennkammer (7) eines Wasserheizers angeordnet ist, einem diesen vorzugsweise in Richtung der Abgase im üblichen Betrieb durchströmenden mittels einer Plasmaquelle aus einem Prozeßgas erzeugten Plasmastrom ausgesetzt wird, dem SiO₂, Al₂O₃, Si-Verbindungen, Ti-Verbindungen oder deren Mischungen im flüssigen oder gasförmigen Zustand zugesetzt wird.

2. Verfahren nach Anspruch 1, **dadurch gekennzeichnet, dass** die Beschichtung bei Atmosphärendruck oder unter Grobvakuum durchgeführt wird.

## Claims

1. A process for coating a heat exchanger, especially a coiled tube heat exchanger (1), **characterised in that** the heat exchanger (1), which is arranged in a combustion chamber (7) of a water heater, is exposed to a plasma stream produced from a process gas by means of a plasma source and flowing through the heat exchanger preferably in the direction of the exhaust gases in ordinary operation, to which plasma stream SiO₂, Al₂O₃, Si compounds, Ti compounds or any mixtures thereof in an either liquid or gaseous state are added.

2. A process according to Claim 1 **characterised in that** the said coating is effected at atmospheric pressure or under a low vacuum.

## Revendications

1. Procédé d'enduction d'un échangeur thermique, notamment d'un échangeur thermique à tuyau hélicoïdal (1), **caractérisé en ce que** l'échangeur thermique (1) qui est disposé dans une chambre de combustion (7) d'un appareil de production d'eau chaude, est soumis à un courant de plasma parcourant celui-ci de préférence dans la direction des gaz d'échappement en fonctionnement usuel, généré au moyen d'une source de plasma à partir d'un gaz de processus, courant auquel sont ajoutés SiO₂, Al₂O₃, des composés Si, des composés Ti ou leurs mélanges à l'état liquide ou gazeux.

2. Procédé selon la revendication 1, **caractérisé en ce que** l'enduction est réalisée à la pression atmosphérique ou sous vide grossier.
